(19) Europäisches Patentamt
European Patent Office
Office européen des brevets

(11) **EP 2 754 730 B1**

(12) **EUROPEAN PATENT SPECIFICATION**

(45) Date of publication and mention
of the grant of the patent:
**13.12.2017 Bulletin 2017/50**

(21) Application number: **12830845.9**

(22) Date of filing: **31.08.2012**

(51) Int Cl.:
*C23C 14/34* (2006.01)     *C23C 14/06* (2006.01)
*C23C 14/56* (2006.01)     *H01J 37/34* (2006.01)
*H01J 37/32* (2006.01)

(86) International application number:
**PCT/JP2012/072116**

(87) International publication number:
**WO 2013/035634 (14.03.2013 Gazette 2013/11)**

(54) **CARBON FILM FORMING APPARATUS**

VORRICHTUNG ZUR HERSTELLUNG VON KOHLENSTOFFFOLIEN

APPAREIL DE FORMATION D'UN FILM DE CARBONE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.09.2011 JP 2011194954**

(43) Date of publication of application:
**16.07.2014 Bulletin 2014/29**

(73) Proprietor: **Nanotec Co.**
**Chiba 277-0872 (JP)**

(72) Inventors:
• **NAKAMORI Hideki**
**Kashiwashi**
**Chiba 277-0872 (JP)**
• **HIRATSUKA Masanori**
**Kashiwa**
**Chiba 277-0872 (JP)**

• **YUKIMURA Ken**
**Kashiwashi**
**Chiba 277-0872 (JP)**

(74) Representative: **Müller Hoffmann & Partner**
**Patentanwälte mbB**
**St.-Martin-Strasse 58**
**81541 München (DE)**

(56) References cited:
**JP-A- 2000 352 506     JP-A- 2004 143 535
JP-A- 2011 214 150     US-A- 5 643 343**

• **CZYZNIEWSKI ET AL: "Preparation and
characterisation of a-C and a-C:H coatings
deposited by pulsed magnetron sputtering",
SURFACE AND COATINGS TECHNOLOGY,
ELSEVIER, AMSTERDAM, NL, vol. 203, no. 8, 15
January 2009 (2009-01-15), pages 1027-1033,
XP025799756, ISSN: 0257-8972, DOI:
10.1016/J.SURFCOAT.2008.09.027 [retrieved on
2008-12-16]**

# EP 2 754 730 B1

## Description

### TECHNICAL FIELD

The present invention relates to a carbon film forming apparatus that is used for processing and forming a high-grade carbon film or especially an intrinsic carbon film on a surface of a material to be processed as a target at a high speed.

### BACKGROUND ART

As a carbon film, there has been conventionally known a DLC film that is formed on a surface of a sliding part of, e.g., a cutting tool or a bearing. As methods for manufacturing a DLC film, various methods have been conventionally suggested, and a low-hydrogen carbon film having the extremely low content of hydrogen or a carbon film hardly containing hydrogen (which is a so-called intrinsic carbon film) is present in recent years. Since the low-hydrogen carbon film or the intrinsic carbon film has abrasion resistance or durability as a film and also has high hardness, it is used as a surfacing material for various kinds of materials to be processed, e.g., electrodes, molds, tools, machine parts, and others.

In general, a DLC film whose hydrogen content is 0.5% or more and 5% or less is formed by each of a cathode arc method, a filtered arc method, a laser abrasion method, and a sputtering method.

As the sputtering method, a method disclosed in Patent Literature 3 is known.

As a method for forming a DLC film at a high speed, a method disclosed in Patent Literature 4 is known. According to the film formation based on this method, it is possible to increase a deposition rate up to 10 $\mu$m/h.

US 5 643 343 A discloses an abrasive material for the precision treatment of surfaces. This material may be in the form of an abrasive layer adhered by chemical and/or physical bonds to a carrier, the latter preferably made of a flexible material such as plastic. The abrasive material is preferably obtained from the pulse-flows of an accelerated electroerosive plasma.

### CITATION LIST

### PATENT LITERATURES

Patent Literature 1: Japanese Published Patent Application Publication No. 2003-147508
Patent Literature 2: Japanese Published Patent Application Publication No. 2008-297171
Patent Literature 3: Japanese Published Patent Application Publication No. 2007-70667
Patent Literature 4: Japanese Published Patent Application Publication No. 2010-174310

### DISCLOSURE OF INVENTION

### PROBLEM TO BE SOLVED BY THE INVENTION

However, in DC magnetron sputtering of a single vacuum container, there is a problem that film quality and a deposition rate are fixed by determining a voltage supplied from a power supply that generates plasma, and selection of a film thickness or film quality meeting a take-up rate is impossible in, e.g., a roll type laminated carbon film forming apparatus.

According to Patent Literature 4, in a PVD method including the magnetron sputtering method, a deposition rate is said to be 1 $\mu$m/h, and it is hard to say that productivity is excellent.

In view of the above-described background, it is an object of the present invention to form a carbon film that is uniform and appropriate for use applications without fine adjustment of a take-up rate in a roll type laminated carbon film forming apparatus.

### MEANS FOR SOLVING PROBLEM

To solve the problem and achieve the object, there is provided a carbon film forming apparatus according to the present invention, comprising: an unwinding vacuum chamber having a rolled material to be processed that is installed therein; a film forming vacuum chamber used for processing the material to be processed that is unwound from the unwinding vacuum chamber; and a take-up vacuum chamber used for taking up into a roll shape the material to be processed that is processed in the film forming vacuum chamber, the film forming vacuum chamber comprising: a substrate to which a predetermined voltage is applied by substrate voltage applying means in a vacuum chamber in which depressurization to a predetermined degree of vacuum is possible; and a plasma generating source that has at least one carbon raw material substrate that is arranged to face the substrate, forms plasma from an atmosphere for discharge generation introduced into the vacuum chamber based on adjustment electric power output to the carbon raw material substrate by a pulse power supply on the carbon raw material substrate, and discharges electricity together with a carbon raw material from the carbon raw material substrate toward the material to be processed that is held on the substrate, wherein a carbon film is processed and formed on a surface of the material to be processed by a sputtering method, the pulse power supply and the substrate voltage applying means are connected by an oscillation apparatus for a gate signal and a mechanism that adjusts an initial voltage, the pulse power supply has an adjustment circuit that controls a pulse width in the range of 1 $\mu$s to 200 $\mu$s, delay timing from application of a voltage to the carbon raw material substrate as a target to application of a substrate voltage in the range of 0 $\mu$s to 200 $\mu$s, a frequency in the range of 50 Hz to 2000 Hz, and a voltage in the range of 700 V to 2000 V, and the substrate voltage applying means has an adjustment circuit that controls a pulse width in the range of 10 $\mu$s to 200 $\mu$s, delay timing from application of a voltage to the substrate as a target to application of the substrate voltage in the range of 0 $\mu$s to 200 $\mu$s, a frequency in the range of 50 Hz to 2000 Hz, and a voltage in the range of 0 V to 500 V.

The carbon film forming apparatus according to the present invention is characterized in that current density that is output to the carbon raw material substrate by the pulse power supply is controlled in the range of 0.1 kA/m$^2$ to 6 kA/m$^2$ per unit area

The carbon film forming apparatus according to the present invention is characterized in that controlling the electric power applied to the carbon raw material substrate by the pulse power supply in the range of 0.5 kW/m$^2$ to 3000 kW/m$^2$ per unit area enables controlling hardness and a deposition rate in a given region.

The carbon film forming apparatus according to the present invention is characterized in that the carbon raw material substrate is equipped with a gauge head that measures a temperature and a mechanism that adjusts a temperature, and performing heating until a surface temperature of the carbon raw material substrate reaches 1000°C or more and controlling a vapor pressure of the raw material evaporated from the raw material substrate to reach 0.001 Pa to 130 Pa enables controlling hardness/a deposition rate in a given region.

The carbon film forming apparatus according to the present invention is characterized in that adjusting values of a voltage and a current output to the carbon raw material substrate with the use of an impedance matching resistance enables controlling impedance in the apparatus with respect to each circuit to fall within the range of 20% to 70%.

The carbon film forming apparatus according to the present invention is characterized in that a voltage applied to the substrate by the substrate voltage applying means is allowed to be set in the range of 0 to 500 V and, when the substrate voltage applied by the substrate voltage applying means is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means is applied during the pattern (1) from the target voltage On to the target voltage Off.

The carbon film forming apparatus according to the present invention is characterized in that a voltage applied to the substrate by the substrate voltage applying means is allowed to be set in the range of 0 to 500 V and, when the substrate voltage applied by the substrate voltage applying means is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means is applied during the pattern (2) from the target voltage Off to the end of film formation.

The carbon film forming apparatus according to the present invention is characterized in that a voltage applied to the substrate by the substrate voltage applying means is allowed to be set in the range of 0 to 500 V and, when the substrate voltage applied by the substrate voltage applying means is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means is applied during the pattern (3) from the target voltage On to the end of film formation.

The carbon film forming apparatus according to the present invention is characterized in that the substrate voltage applying means is a pulse power supply that outputs a pulse voltage to the substrate, and the pulse voltage is synchronized with a pulse voltage in the adjustment electric power output to the carbon raw material substrate by the pulse power supply of the plasma generating source or delayed in the range of 1 $\mu$sec to 200 $\mu$sec.

The carbon film forming apparatus according to the present invention is characterized in that adjusting a gap between the carbon raw material substrate and the material to be processed in the range of 30 mm to 200 mm enables adjusting a deposition rate of a carbon film formed by any carbon film forming apparatus described above in the range of 1 nm per minute to 700 nm per hour.

The carbon film forming apparatus according to the present invention is characterized in that a carbon film formed by any carbon film forming apparatus described above is adjustable to have a characteristic band having a peak in 800 to 200 cm-1 and a peak intensity ratio of a G band and a D band that is 0.4 or more and 2.0 or less or an intensity area ratio that is 1.5 or more and 3.2 or less in Raman optical spectra using a YAG laser.

The carbon film forming apparatus according to the present invention is characterized in that installing the substrate for holding the material to be processed as a substrate in the film forming vacuum chamber enables operating the film forming vacuum chamber alone.

The carbon film forming apparatus according to the present invention is characterized in that the material to be processed that is held on the substrate is any one of polyethylene, polyester, polyethylene terephthalate, polyimide, SiC (silicon carbide), an aluminum alloy, alumina, SUJ2 (a high-carbon chromium bearing steel material), WC (tungsten carbide), an Si wafer, a fiber product, and biodegradable plastic.

The carbon film forming apparatus according to the present invention is characterized in that a gas that is introduced into the vacuum chamber can be any one of nitrogen, argon, krypton, oxygen, a hydrocarbon-based gas, and a mixed gas of these materials.

The carbon film forming apparatus according to the present invention is characterized in that the carbon raw material substrate arranged to face the substrate in the film forming vacuum chamber contains carbon as a main material and also contains one or more selected from titanium, silicon, aluminum, zirconium, zinc, and tungsten.

EFFECT OF THE INVENTION

The carbon film forming apparatus according to the present invention exercises the effect that a carbon film that is uniform and appropriate for use applications can be formed without fine adjustment of a take-up rate in the roll type laminated carbon film forming apparatus.

BRIEF DESCRIPTION OF DRAWINGS

FIG. 1 is a view showing an internal configuration of a film forming vacuum chamber of a carbon film forming apparatus according to an embodiment of the present invention;

FIG. 2 is a circuit diagram showing outline configurations of a pulse power supply, a pulse generation mechanism, and substrate voltage applying means according to the embodiment of the present invention;

FIG. 3 is a view showing an internal configuration of the carbon film forming apparatus according to the embodiment of the present invention;

FIG. 4 is a view showing Raman spectra, in which an axis of ordinate represents scattering intensity and an axis of abscissa represents a wavenumber;

FIG. 5 is a graph showing a relationship between a voltage applied to a carbon raw material substrate 5 and a deposition rate of a carbon film formed on a material to be processed 4;

FIG. 6 is a graph that shows data obtained by measuring each volume resistivity of the carbon film formed while changing conditions of a target voltage in many ways and also shows conductivity the carbon film formed with the use of the carbon raw material substrate obtained by using carbon as a main material and tungsten as an auxiliary material; and

FIG. 7 is a graph showing oxygen permeability of a carbon film (an intrinsic carbon film) formed by the apparatus according to the present invention in comparison to that obtained by using a base material alone and that obtained by forming a diamond-like carbon layer (a DLC layer) relative to the base material.

BEST MODE(S) FOR CARRYING OUT THE INVENTION

An embodiment of a carbon film forming apparatus according to the present invention will now be described hereinafter with reference to the drawings. It is to be noted that the present invention is not restricted by the following embodiment.

Operations/effects obtained by the present invention will now be described.

A carbon film forming apparatus according to the present invention is a carbon film forming apparatus having an unwinding vacuum chamber in which a rolled material to be processed is installed, a film forming vacuum chamber that is used for processing the material to be processed that is unwound from the unwinding vacuum chamber, and a take-up vacuum chamber used for taking up the material to be processed that is processed in the film forming vacuum chamber into a roll shape, the apparatus including, in a vacuum chamber that can be depressurized to a predetermined degree of vacuum, a substrate which holds the material to be processed and to which a predetermined voltage is applied by substrate voltage applying means and a plasma generating source which forms plasma from a discharge generation atmosphere introduced into the vacuum chamber based on adjustment electric power output to a carbon raw material substrate by a pulse power supply on the carbon raw material substrate arranged to face the substrate and discharges electricity together with the carbon raw material from the carbon raw material substrate toward the material to be processed that is held on the substrate, a carbon film forming apparatus for processing and forming a carbon film on a surface of the material to be processed by a sputtering method is adopted, the pulse power supply and the substrate voltage applying means are connected to a gate signal oscillation apparatus by a mechanism that adjusts an initial voltage, respective adjustment circuits each of which independently controls a pulse width, delay timing from application of a voltage to the a target to application of a substrate voltage, a frequency, and a voltage, respectively are provided, and the pulse width, the delay timing from the application of a voltage to a target to the application of a substrate voltage, the frequency, and the voltage are controlled, respectively, thereby adjusting density of the plasma around the carbon raw material substrate to an appropriate value. The pulse power supply has an adjustment circuit that controls, e.g., a pulse width in the range of 1 $\mu$s to 200 $\mu$s, delay timing from application of voltage to the carbon raw material substrate (a target) to application of a substrate voltage in the range of 0 $\mu$s to 200 $\mu$s, a frequency in the range of 50 Hz to 2000 Hz, and a voltage in the range of 700 V to 2000 V, and the substrate power supply applying means has an adjustment circuit that controls, e.g., a pulse width in the range of 10 $\mu$s to 200 $\mu$s, delay timing from application of a voltage to the substrate (a target) to application of a substrate voltage in the range of 0 $\mu$s to 200 $\mu$s, a frequency in the range of 50 Hz to 2000 Hz, and a voltage in the range of 0 V to 500 V. As a result, in the roll type laminated carbon film forming apparatus can provide an effect of enabling formation of a uniform high-grade carbon film on a surface of the material to be processed in the film forming vacuum chamber without fine adjustment of a take-up rate.

In the carbon film forming apparatus according to the present invention, when density of a current output to the carbon raw material substrate by the pulse power supply is controlled in the range of 0.1 kA/m$^2$ to 6 kA/m$^2$ per unit area and its appropriate discharge current density is controlled in the range of 1 kA/m$^2$ to 6 kA/m$^2$, the density of plasma around the carbon raw material substrate can be adjusted to an appropriate value, and it is possible to obtain an effect that a uniform high-grade carbon film can be formed on the surface of the material to be processed in the film forming vacuum chamber by using the roll type laminated carbon film forming apparatus without fine adjustment of a take-up rate.

Further, when the electric power applied to the carbon raw material substrate by the pulse power supply is controlled in the range of 0.5 kW/m$^2$ to 3000 kW/m$^2$ per unit area, the density of the plasma around the carbon raw material substrate can be adjusted to an appropriate value, whereby a uniform high-grade carbon film can be formed on the surface of the material to be processed in the film forming vacuum chamber by using the roll type laminated carbon film forming apparatus without fine adjustment of a take-up rate.

Furthermore, the carbon raw material substrate is equipped with a gauge head for measuring a temperature and a mechanism for adjusting a temperature and, when heating is carried out until a surface temperature of the carbon raw material substrate increases to 1000°C or more and a vapor pressure of a raw material that evaporates from the raw material substrate is controlled to be 0.001 Pa to 130 Pa, it is possible to obtain an effect that a deposition rate can be further raised by using a constituent that is the vapor pressure of carbon in addition to conventional plasma sputtering. Moreover, these effects were also confirmed in targets that are titanium, tungsten, and chrome.

Here, when values of a voltage and a current output to the carbon raw material substrate are adjusted by an impedance matching resistance, impedance in the apparatus relative to the circuit can be controlled to 20% to 70%.

Additionally, the voltage applied to the substrate by the substrate voltage applying means can be set in the range of 0 to 500 V and, when the substrate voltage applied by the substrate voltage applying means is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means is applied during the pattern (1) from the target On to the target voltage Off, and hence the carbon film can be formed on the surface of the material to be processed in a state that the density of the plasma around the carbon raw material substrate is adjusted to an appropriate value, thus obtaining an effect that the excellent high-grade carbon film can be assuredly formed.

Further, the voltage applied to the substrate by the substrate voltage applying means can be set in the range of 0 to 500 V and, when the substrate voltage applied by the substrate voltage applying means is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means is applied during the pattern (2) from the target voltage Off to the end of the film forming time, and hence the carbon film can be formed on the surface of the material to be processed in a state that the density of the plasma around the carbon raw material substrate is adjusted to an appropriate value, thus obtaining an effect that the excellent high-grade carbon film can be assuredly formed.

Furthermore, the voltage applied to the substrate by the substrate voltage applying means can be set in the range of 0 to 500 V and, when the substrate voltage applied by the substrate voltage applying means is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means is applied during the pattern (3) from the target voltage On to the end of the film forming time, and hence the carbon film can be formed on the surface of the material to be processed in a state that the density of the plasma around the carbon raw material substrate is adjusted to an appropriate value, thus obtaining an effect that the excellent high-grade carbon film can be assuredly formed.

Moreover, the substrate voltage applying means is the pulse power supply that outputs a pulse voltage to the substrate, the pulse voltage to be output is synchronized with a pulse voltage in adjustment electric power that is output to the carbon raw material substrate by the pulse power supply that is the plasma generating source or it is delayed in the range of 1 μsec to 200 μsec, and hence the carbon film is formed on the surface of the material to be processed in a state that the density of the plasma around the carbon raw material substrate is adjusted to an appropriate value, thereby obtaining the effect that the excellent high-grade carbon film can be assuredly formed.

Additionally, the deposition rate of the carbon film formed by the carbon film forming apparatus can be adjusted in the range of 1 nm per minute to 700 nm per hour by adjusting a gap between the carbon raw material substrate and the material to be processed in the range of 30 mm to 200 mm, and it is possible to obtain the effect that the uniform high-grade carbon film can be formed on the surface of the material to be processed in the film forming vacuum chamber by the roll type laminated carbon film forming apparatus without fine adjustment of the take-up rate.

Here, the carbon film formed by any carbon film forming apparatus described above can be adjusted to have a characteristic band having a peak in 800 to 200 cm-1 and a peak intensity ratio of a G band and a D band that is 0.4 or more and 2.0 or less or an intensity area ratio that is 1.5 or more and 3.2 or less in Raman optical spectra using a YAG laser.

Further, since the film forming vacuum chamber alone can be operated by installing a substrate that holds the material to be processed as the substrate in the film forming vacuum chamber, it is possible to obtain the effect that the invention can be also used as a batch type carbon film forming apparatus when a laminated film is not required.

The material to be processed that is held on the substrate can be any one of polyethylene, polyester, polyethylene terephthalate, polyimide, SiC (silicon carbide), an aluminum alloy, alumina, SUJ2 (a high-carbon chromium bearing steel material), WC (tungsten carbide), an Si wafer, a fiber product, and biodegradable plastic.

A gas that is introduced into the vacuum chamber can be any one of nitrogen, argon, krypton, oxygen, and a hydrocarbon-based gas, or a mixed gas of these materials.

An embodiment according to the present invention will now be described.

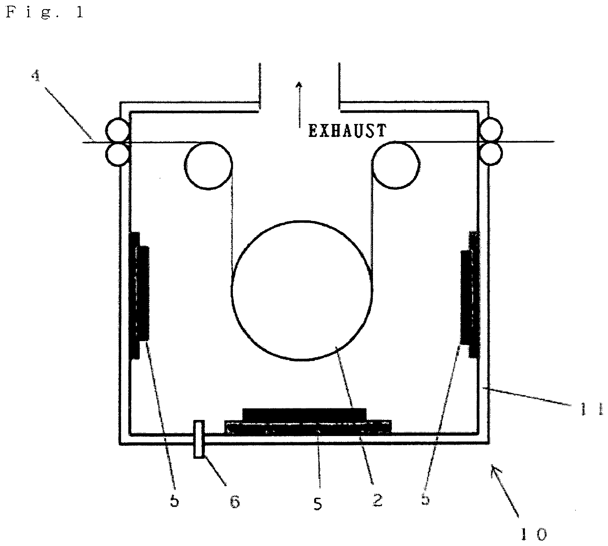

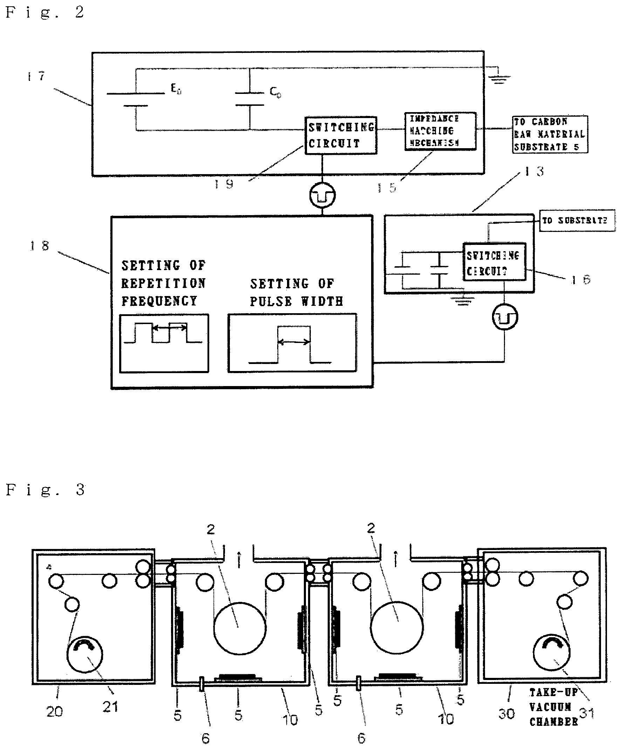

FIG. 1 is a view sowing an internal configuration of a film forming vacuum chamber 10 in a carbon film forming apparatus according to an embodiment of the present invention. FIG. 2 is a circuit diagram showing outline configurations of a pulse power supply 17, a pulse generation mechanism 18, and substrate voltage applying means 13 according to this embodiment. FIG. 3 is a view showing an internal configuration of the carbon film forming apparatus according to this embodiment.

The carbon film forming apparatus according to this embodiment includes film forming vacuum chambers 10, an unwinding vacuum chamber 20, and a take-up vacuum chamber 30. In an example shown in FIG. 3, the unwinding vacuum chamber 20, the two film forming vacuum chambers 10, and the take-up vacuum chamber 30 are arranged in the mentioned order. Here, one film forming vacuum chamber 10 alone may be provided, or

three or more film forming vacuum chambers 10 may be aligned.

As shown in FIG. 1 or FIG. 3, the film forming vacuum chamber 10 can be evacuated in an arrow direction by operating a non-illustrated vacuum pump, and a pressure can be reduced to a predetermined degree of vacuum. A substrate 2 is arranged in a vacuum chamber 11 of the film forming vacuum chamber 10, and a predetermined voltage is applied to the substrate 2 by substrate voltage applying means 13 shown in FIG. 2. The substrate voltage applying means 13 applies a pulse voltage or a direct-current voltage for the substrate 2.

A material to be processed 4 can be held on a surface of the substrate 2. The material to be processed 4 is wound in a roll shape around an unwinding roll 21 arranged in the unwinding vacuum chamber 20. This material to be processed 4 is unwound from the unwinding vacuum chamber 20, processed into a carbon film while being held on the substrate 2 in the film forming vacuum chamber 10, and then taken up into a roll shape by a take-up roll 31 in the take-up vacuum chamber 30.

A carbon raw material substrate 5 as a plasma generating source is provided in each film forming chamber 10 in a state that this substrate is arranged to face the substrate 2. Here, the carbon raw material substrate 5 might contain carbon as a main material and also contain an auxiliary material that is one or more selected from titanium, silicon, aluminum, zirconium, zinc, and tungsten. It is to be noted that the auxiliary material that is one or more selected from titanium, silicon, aluminum, zirconium, zinc, and tungsten might be contained in the range of 0.1% to 30% relative to the carbon as a main material. Further, the carbon raw material substrate 5 can contain one or more materials selected from titanium, silicon, aluminum, zirconium, zinc, and tungsten in the range of 0.1% to 99.99% with respect to the carbon without containing the carbon as a main component. A pulse power supply 17 for the carbon raw material substrate 5 is connected to the carbon raw material substrate 5. The vacuum chamber 11 is provided with a gas introduction port 6 so that an atmosphere for discharge generation can be introduced into the film forming vacuum chamber 10 from the gas introduction port 6. Furthermore, the carbon raw material substrate 5 is provided with a gauge head (not shown) that measures a temperature and a mechanism (not shown) that is used to adjust a temperature.

A pulse generation mechanism 18 is connected to the substrate voltage applying means 13 and the pulse power supply 17 for the carbon raw material substrate. The pulse generation mechanism 18 can set and adjust a voltage applied to the substrate 2 by the substrate voltage applying means 13 to a predetermined voltage value and also can set and adjust a value of adjustment electric power output from the pulse power supply 17 for the carbon raw material substrate to the carbon raw material substrate 5 to a predetermined value. Moreover, the pulse generation mechanism 18 can set and adjust an application time of a pulse voltage in the adjustment electric power output to the carbon raw material substrate 5 to a predetermined value.

Such a configuration enables the carbon film forming apparatus according to this embodiment to depressurize the vacuum chamber 11 to a predetermined degree of vacuum, clean the surface of the material to be processed by plasma irradiation based on electric discharge, and apply a predetermined voltage (the target voltage On) to the substrate 2 by an operation of the substrate voltage applying means 13 based on an instruction from the pulse generation mechanism 18 in this state. Additionally, it is possible to output the adjustment electric power from the pulse power supply 17 to the carbon raw material substrate 5 based on an instruction from the pulse generation mechanism 18. As a result, plasma can be formed from the atmosphere for discharge generation that is introduced into the film forming vacuum chamber 10 from the gas introduction port 6 based on the adjustment electric power output from the pulse power supply 17 to the carbon raw material substrate 5, whereby a plasma arc is generated together with the carbon raw material from the carbon raw material substrate 5 toward the material to be processed 4 that is held on the substrate 2. As a result, the carbon film can be processed and formed (film formation) on the surface of the material to be processed 4 by the plasma arc. In case of terminating the film formation, the target voltage is set to OFF.

Here, the substrate voltage applying means 13 applies a pulse voltage or a direct-current voltage for the substrate 2, and the pulse generation mechanism 18 applies a voltage in a state that the substrate 2 is set and adjusted in the range of 0 to 500 V in case of first applying the direct-current voltage. On the other hand, as to the adjustment electric power output from the pulse power supply 17 for the carbon raw material substrate 5 to the carbon raw material substrate 5, a value and a pulse voltage application time thereof are set and adjusted to predetermined values by the pulse generation mechanism 18, and a current thereof is controlled in the range of 0.1 kA/m$^2$ to 6 kA/m$^2$ per unit area.

Further, as the pulse power supply 17 that outputs the adjustment electric power, such a circuit as shown in FIG. 2 can be adopted. This circuit can charge a capacitor C0 with an output from a high-voltage stabilized direct-current power supply, convert its energy into a pulse form with the use of a switching circuit 19, and supply and output the converted energy to the carbon raw material substrate 5 as high-power pulses. As the switching circuit 19 used here, it is possible to adopt a circuit employing a high-power IGBT element that uses a pulse signal oscillated by the pulse generation mechanism 18 as a gate signal as well as a switching element employing an FET element for high-speed response.

In 13, likewise, the capacitor can be charged with an output from the high-voltage stabilized direct-current power supply, its energy can be converted into a pulse form by a switching circuit 16, and the converted energy can be supplied and output to the substrate 2 as high-power pulses.

Furthermore, an impedance matching mechanism 15 is disposed to the pulse power supply 17 that outputs the adjustment electric power, and it can control impedance of the entire circuit relative to a current flowing through the carbon raw material substrate 5 to 20% to 70% by using a variable resistance (an impedance matching resistance).

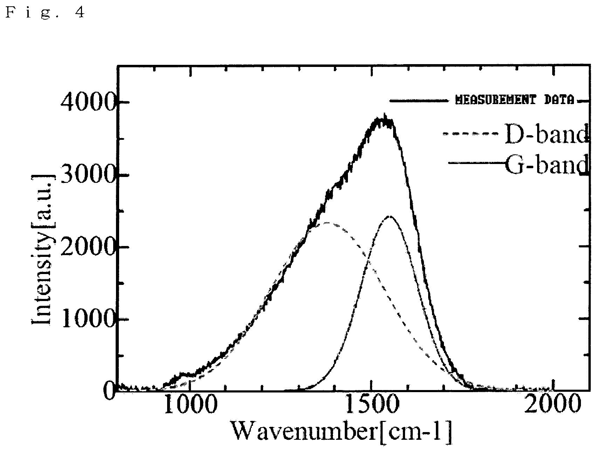

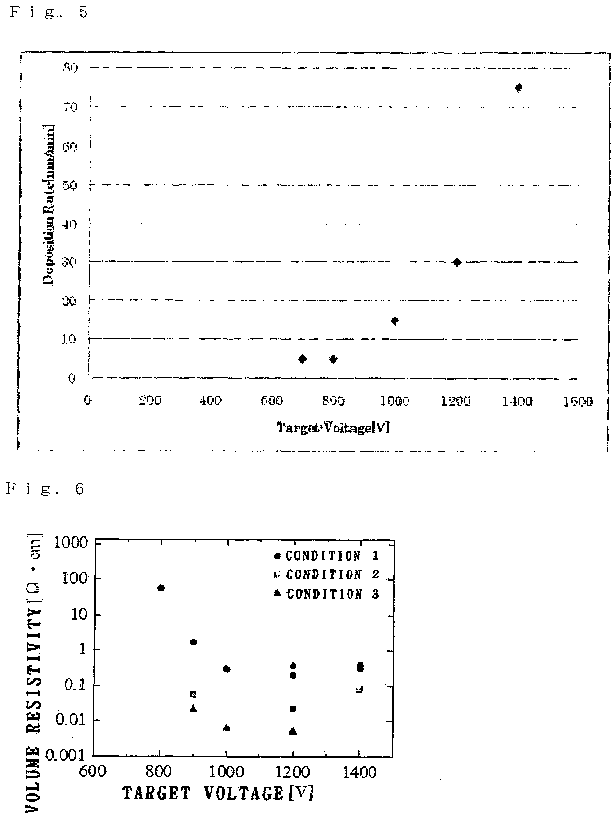

FIG. 4 is a view showing Raman spectra in which an axis of ordinate represents scattering intensity and an axis of abscissa represents a wavenumber. FIG. 5 is a graph showing a relationship between a voltage applied to the carbon raw material substrate 5 and a deposition rate of the carbon film formed on the material to be processed 4. FIG. 4 shows both measurement data of the carbon film formed by the carbon film forming apparatus according to this embodiment and spectra of a D-band and a G-band.

It was confirmed from FIG. 4 that the carbon film formed by the carbon film forming apparatus according to this embodiment is a typical DLC film with a characteristic band having a peak in the range of 800 to 2000 cm-1 in the Raman optical spectra using a YAG laser. Further, FIG. 5 shows how a deposition rate of the carbon film formed on the material to be processed 4 varies by a voltage applied to the carbon raw material substrate 5.

Examples will now be described hereinafter.

(Example 1)

In adjustment electric power from the pulse power supply 17 that is output to a 12.7x20.32-cm (5x8-inch) carbon target (the carbon raw material substrate 5), a pulse voltage that is 0.8 kV at a peak and 0.61 kV at a stabilized part was applied for 100 μs, and pulse peak electric power was output under conditions of 3.2 kW. Furthermore, a voltage applied to the substrate 2 by the substrate voltage applying means 13 were set to 0 V. An Ar gas pressure was set to 3.38x10-1 Pa. As characteristics of a carbon film formed under such conditions (an intrinsic carbon film), a film thickness was 0.60 μm, and hardness was 1190 in terms of a Vickers converted value HV.

(Example 2)

In adjustment electric power from the pulse power supply 17 that is output to a 12.7x20.32-cm (5x8-inch) carbon target (the carbon raw material substrate 5), a pulse voltage that is 1.0 kV at a peak and 0.61 kv at a stabilized part was applied for 100 μs, and pulse peak electric power was output under conditions of 8.14 kW. Furthermore, a voltage applied to the substrate 2 by the substrate voltage applying means 13 was set to 0 V. An Ar gas pressure was set to $3.38 \times 10$-1 Pa. As characteristics of a carbon film formed under such conditions (an intrinsic carbon film), a film thickness was 0.60 μm, and hardness was 890 in terms of a Vickers converted value HV.

(Example 3)

In adjustment electric power from the pulse power supply 17 that is output to a 12.7x20.32-cm (5x8-inch) carbon target (the carbon raw material substrate 5), a pulse voltage that is 1.2 kV at a peak and 0.61 kV at a stabilized part was applied for 100 μs, and pulse peak electric power was output under conditions of 24.2 kW. Furthermore, a voltage applied to the substrate 2 by the substrate voltage applying means 13 was set to 0 V. An Ar gas pressure was set to $3.38 \times 10$-1 Pa. As characteristics of a carbon film formed under such conditions (an intrinsic carbon film), a film thickness was 0.60 μm, and hardness was 1010 in terms of a Vickers converted value HV.

(Example 4)

In adjustment electric power from the pulse power supply 17 that is output to a 12.7x20.32-cm (5x8-inch) carbon target (the carbon raw material substrate 5), a pulse voltage that is 1.4 kV at a peak and 0.61 kV at a stabilized part was applied for 100 μs, and pulse peak electric power was output under conditions of 43.3 kW. Furthermore, a voltage applied to the substrate 2 by the substrate voltage applying means 13 was set to 0 V. An Ar gas pressure was set to $3.38 \times 10$-1 Pa. As characteristics of a carbon film formed under such conditions (an intrinsic carbon film), a film thickness was 0.60 μm, and hardness was 680 in terms of a Vickers converted value HV.

(Example 5)

In adjustment electric power from the pulse power supply 17 that is output to a 12.7x20.32-cm (5x8-inch) carbon target (the carbon raw material substrate 5), a pulse voltage that is 1.2 kV at a peak and 0.61 kV at a stabilized part was applied for 160 μs, and pulse peak electric power was output under conditions of 56.2 kW. Furthermore, a voltage applied to the substrate 2 by the substrate voltage applying means 13 was set to 0 V. An Ar gas pressure was set to 1.51x10-1 Pa. As characteristics of a carbon film formed under such conditions (an intrinsic carbon film), a film thickness was 3.20 μm, and hardness was 178 in terms of a Vickers converted value HV. Moreover, as the characteristics of the carbon film under such conditions (the intrinsic carbon film), volume resistivity was $1.66 \times 10$-1 Ω·cm.

In hardness measurement, if a micro-Vickers or Knoop test that is a conventional method is applied as a hardness test of a thin film, since an influence of a base material is considerable and hardness of the thin film itself is not clear when a critical value is exceeded from a film thickness, it is generally said that an indentation depth must be suppressed to 10% or less of the film thickness (however, this value depends on the quality of a base material and the film characteristics) in order to suppress this influence. Therefore, a nonindentation method was developed, and the hardness measurement of a thin film was enabled. Moreover, in 2002, a draft of the nonindentation method was created as ISO14577 and acknowledged worldwide. According to a calculation method described in ISO14577, there is indentation hardness (HIT), and it is represented by using a projection contact area Ap and a maximum load Fmax like the following Expression (1).

[Expression 1]

$$H_{IT} = \frac{F\max}{Ap} \quad \cdots \quad (1)$$

A calculation method of a Vickers converted value using a modified Berkovic indenter is represented by Expression (2). It is to be noted that, as analysis conditions, an indentation load was set to 1 mN, and a load application rate was set to 2 mN/min.

[Expression 2]

$$HV = 0.0926 \times H_{it} \quad \ldots \quad (2)$$

(Example 6)

In adjustment electric power from the pulse power supply 17 that is output to a 12.7x20.32-cm (5x8-inch) carbon target containing a metal (the carbon raw material substrate 5), a pulse voltage that is 1.0 kV at a peak and 0.61 kV at a stabilized part was applied for 100 $\mu$s, and pulse peak electric power was output under conditions of 56.2 kW. Furthermore, a voltage applied to the substrate 2 by the substrate voltage applying means 13 was set to 0 V. An Ar gas pressure was set to $1.51 \times 10$-1 Pa. As characteristics of a carbon film formed under such conditions (an intrinsic carbon film), volume resistivity was $6.3 \times 10$-3 $\Omega \cdot$cm.

(Example 7)

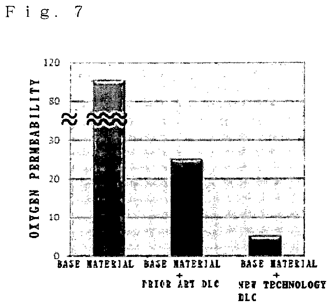

In adjustment electric power from the pulse power supply 17 that is output to a 12.7x20.32-cm (5x8-inch) carbon target (the carbon raw material substrate 5), a pulse voltage that is 1.0 kV at a peak and 0.61 kV at a stabilized part was applied for 100 $\mu$s, and pulse peak electric power was output under conditions of 56.2 kW. Furthermore, a voltage applied to the substrate 2 by the substrate voltage applying means 13 was set to 0 V. An Ar gas pressure was set to 1.51x10-1 Pa. As characteristics of a carbon film formed under such conditions (an intrinsic carbon film), a film thickness was 49 nm, gas permeability for oxygen was 2.46x10-5 g / m$^2 \cdot$ day $\cdot$ Pa (2.5 cc / (m$^2 \cdot$ day $\cdot$ atm)), and gas permeability for vapor was 2.46x10-5 g / m$^2 \cdot$ day $\cdot$ Pa (9.0 g / (m$^2 \cdot$ day $\cdot$ atm)). Here, FIG. 7 shows oxygen permeability of a base material alone and a counterpart of a base material having a film of a diamond-like carbon layer (a DLC layer) formed thereon in comparison to each other. Here, the oxygen permeability of a hydrogen-free carbon film (an intrinsic carbon film) according to the present invention is shown at a right end, and it can be understood that the oxygen permeability is extremely low and gas barrier properties are improved as compared with the film of the DLC layer.

(Example 8)

In adjustment electric power from the pulse power supply 17 that is output to a 12.7x20.32-cm (5x8-inch) carbon target containing silicon (the carbon raw material substrate 5), of a pulse voltage that is 1.0 kV at a peak and 0.61 kV at a stabilized part was applied for 100 $\mu$s, and pulse peak electric power was output under conditions of 56.2 kW. Furthermore, a voltage applied to the substrate 2 by the substrate voltage applying means 13 was set to 0 V. An Ar gas pressure was set to 1.51x10-1 Pa. As characteristics of a carbon film formed under such conditions (an intrinsic carbon film), a film thickness was 50 nm and gas permeability for vapor was 6.61x10-5 g / m$^2 \cdot$ day $\cdot$ Pa (6.7 g / (m$^2 \cdot$ day $\cdot$ atm)).

In such examples (Examples 1 to 8), when an auxiliary material such as titanium, silicon, aluminum, zirconium, zinc, or tungsten is contained in the carbon as a main material in the carbon raw material substrate 5 as described above, characteristics of the formed carbon film can be changed.

For example, the following Table 1 shows conductivity of a carbon film formed by allowing tungsten to be contained as an auxiliary material in the carbon as a main material. As obvious from Table 1, it can be understood that, when the content of tungsten as the auxiliary material is increased in the range of 0 to 20% with respect to the carbon, the conductivity can be improved.

[Table 1]

|  | CONDITION 1 | CONDITION 2 | CONDITION 3 |
|---|---|---|---|
| **CONTENT OF W** | 0% | 10% | 20% |
| **CONDUCTIVITY** | $3.85 \times 10$-1$\Omega \cdot$cm | $2.25 \times 10$-2 $\Omega \cdot$ cm | 5. $29 \times 10$-3 $\Omega \cdot$ cm |

Additionally, the following Table 2 shows conductivity of a carbon film formed by allowing silicon to be contained as an auxiliary material in the carbon as a main material. As obvious from Table 2, it can be understood that, when the content of silicon as the auxiliary material is increased in the range of 0 to 10% with respect to the carbon, vapor permeability can be reduced.

[Table 2]

|  | 0% | 10% |  |  | 0% | 10% |
|---|---|---|---|---|---|---|

(continued)

| | 0% | 10% | | | 0% | 10% |
|---|---|---|---|---|---|---|
| C-Si | 10 | 6.7 | | C-Si | 9.86x10-5 | 6.62x10-5 |
| VAPOR PERMEABILITY [UNIT : [g / (m$^2$ · day atm)] | | | | Unit: [g / m$^2$ · day · Pa] | | |

Further, as shown in Example 6 in the examples described above, it was also confirmed that the volume resistivity of the carbon film to be formed (the intrinsic carbon film) can be variably adjusted by changing the conditions of the target voltage in many ways (see FIG. 6). Condition 1 shown in FIG. 1 represents conductivity of a carbon film formed with the use of a carbon raw material substrate containing carbon as a main material, and Condition 2 represents conductivity of a carbon film formed by allowing tungsten to be contained 10% as an auxiliary material with respect to carbon as a main material. Furthermore, Condition 3 represents conductivity of a carbon film formed by allowing tungsten to be contained 20% as an auxiliary material with respect to carbon as a main material.

As described above, as to the carbon film (the intrinsic carbon film) formed under the respective conditions shown in the respective examples according to the present invention, the gas permeability of oxygen or the like can be reduced by changing conditions of the carbon film in many ways or gas barrier properties can be arbitrarily set by selecting a target. Moreover, the vapor permeability can be controlled in the range of 0.1 [cc/m$^2$/day] to 20.0 [cc/m$^2$/day]. Additionally, as to the conductivity, it was confirmed that the volume resistivity can be arbitrarily set and controlled in the range of $1.0 \times 10$-3 [$\Omega$·cm] to $1.0 \times 10$2 [$\Omega$·cm] by selecting a target and controlling discharge conditions.

Further, as regards the carbon film to be formed (the intrinsic carbon film), a degree of specularity of its surface can be changed, and the applicant measured values of a refractive index n and an extinction coefficient k of each of the carbon films formed under various conditions by spectroscopic ellipsometry measurement and confirmed that a carbon film having n of 2.5 to 2.7, k of 0.1 to 0.6, high hardness of 22 to 35 GPa, and a resistance value of $1.0 \times 10$1 to $1.0 \times 10$2 [$\Omega$·cm] when a wavelength is 550 nm, a carbon film having n of 2.1 to 2.5, k of 0.6 to 0.8, medium hardness of 9 to 20 GPa, and a resistance value of $1.0 \times 10$-1 to $1.0 \times 10$1 [$\Omega$·cm] when the wavelength is the same, and a carbon film having n of 1.4 to 2.1, k of 0.6 to 0.8, low hardness of 0.04 to 11 GPa, and a resistance value of $1.0 \times 10$-1 to $1.0 \times 10$-2 [$\Omega$·cm] when a wavelength is the same are individually created. Furthermore, as regards the carbon film forming apparatus according to the present invention, it is possible to form a carbon film with respect to the rolled material to be formed and also form a composite film of multiple layers on the surface of the material to be processed, e.g., a film, and each of the thus formed films can be used as a packaging film, a surface protection film of an electrode, a surface sealing film of a circuit pattern, or the like.

INDUSTRIAL APPLICABILITY

As described above, the carbon film forming apparatus according to the present invention is useful for a roll type laminated carbon film forming apparatus.

REFERENCE SIGNS LIST

2       substrate
4       material to be processed
5       carbon raw material substrate
6       gas introduction port
10      film forming vacuum chamber
11      vacuum chamber
13      substrate voltage applying means
15      impedance matching mechanism
16      switching circuit
17      pulse power supply
18      pulse generation mechanism
19      switching circuit
20      unwinding vacuum chamber
21      unwinding roll
30      take-up vacuum chamber

31    take-up roll

**Claims**

1.  A carbon film forming apparatus comprising:

    an unwinding vacuum chamber (20) having a rolled material to be processed (4) that is installed therein;
    a film forming vacuum chamber (10) used for processing the material to be processed (4) that is unwound from the unwinding vacuum chamber (20); and
    a take-up vacuum chamber (30) used for taking up into a roll shape the material to be processed (4) that is processed in the film forming vacuum chamber (10),
    the carbon film forming apparatus is **characterized in that** the film forming vacuum chamber (10) includes:

    a substrate (2) to which a predetermined voltage is applied by substrate voltage applying means (13) in a vacuum chamber (11) in which depressurization to a predetermined degree of vacuum is possible; and
    a plasma generating source that has at least one carbon raw material substrate (5) that is arranged to face the substrate (2), forms plasma from an atmosphere for discharge generation introduced into the vacuum chamber (11) based on adjustment electric power output to the carbon raw material substrate (5) by a pulse power supply (17) on the carbon raw material substrate (5), and discharges electricity together with a carbon raw material from the carbon raw material substrate (5) toward the material to be processed (4) that is held on the substrate (2),
    a carbon film is processed and formed on a surface of the material to be processed (4) by a sputtering method,
    the pulse power supply (17) and the substrate voltage applying means (13) are connected by an oscillation apparatus for a gate signal and a mechanism that adjusts an initial voltage,
    the pulse power supply (17) has an adjustment circuit that controls a pulse width in the range of 1 $\mu$s to 200 $\mu$s, delay timing from application of a voltage to the carbon raw material substrate as a target to application of a substrate voltage in the range of 0 $\mu$s to 200 $\mu$s, a frequency in the range of 50 Hz to 2000 Hz, and a voltage in the range of 700 V to 2000 V, and
    the substrate voltage applying means (13) has an adjustment circuit that controls a pulse width in the range of 10 $\mu$s to 200 $\mu$s, delay timing from application of a voltage to the substrate (2) as a target to application of a substrate voltage in the range of 0 $\mu$s to 200 $\mu$s, a frequency in the range of 50 Hz to 2000 Hz, and a voltage in the range of 0 V to 500 V.

2.  The carbon film forming apparatus according to claim 1, **characterized in that** current density that is output to the carbon raw material substrate (5) by the pulse power supply (17) is controlled in the range of 0.1 kA/m$^2$ to 6 kA/m$^2$ per unit area.

3.  The carbon film forming apparatus according to claim 1, **characterized in that** controlling the electric power applied to the carbon raw material substrate (5) by the pulse power supply (17) in the range of 0.5 kW / m$^2$ to 3000 kW / m$^2$ per unit area enables controlling hardness and a deposition rate in a given region.

4.  The carbon film forming apparatus according to claim 1, **characterized in that** the carbon raw material substrate (5) is equipped with a gauge head that measures a temperature and a mechanism that adjusts a temperature, and performing heating until a surface temperature of the carbon raw material substrate reaches 1000°C or more and controlling a vapor pressure of the raw material evaporated from the raw material substrate (5) to reach 0.001 Pa to 130 Pa enables controlling hardness/a deposition rate in a given region.

5.  The carbon film forming apparatus according to any one of claims 1 to 4, **characterized in that** adjusting values of a voltage and a current output to the carbon raw material substrate (5) with the use of an impedance matching resistance enables controlling impedance in the apparatus with respect to each circuit to fall within the range of 20% to 70%.

6.  The carbon film forming apparatus according to any one of claims 1 to 4, **characterized in that** a voltage applied to the substrate (2) by the substrate voltage applying means (13) is allowed to be set in the range of 0 to 500 V and, when the substrate voltage applied by the substrate voltage applying means (13) is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means (13) is applied during the pattern (1) from the target voltage On to the target voltage Off.

**7.** The carbon film forming apparatus according to any one of claims 1 to 4, **characterized in that** a voltage applied to the substrate (2) by the substrate voltage applying means (13) is allowed to be set in the range of 0 to 500 V and, when the substrate voltage applied by the substrate voltage applying means (13) is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means (13) is applied during the pattern (2) from the target voltage Off to the end of film formation.

**8.** The carbon film forming apparatus according to any one of claims 1 to 4, **characterized in that** a voltage applied to the substrate (2) by the substrate voltage applying means (13) is allowed to be set in the range of 0 to 500 V and, when the substrate voltage applied by the substrate voltage applying means (13) is classified into three patterns, i.e., (1) from a target voltage On to a target voltage Off, (2) from the target voltage Off to end of a film forming time, and (3) from the target voltage On to the end of the film forming time during a total film forming period, the substrate voltage applied by the substrate voltage applying means (13) is applied during the pattern (3) from the target voltage On to the end of film formation.

**9.** The carbon film forming apparatus according to any one of claims 1 to 7, **characterized in that** the substrate voltage applying means (13) is a pulse power supply that outputs a pulse voltage to the substrate (2), and the pulse voltage is synchronized with a pulse voltage in the adjustment electric power output to the carbon raw material substrate (5) by the pulse power supply (17) of the plasma generating source or delayed in the range of 1 $\mu$sec to 200 $\mu$sec.

**10.** The carbon film forming apparatus according to any of claims 1-9, **characterized in that** adjusting a gap between the carbon raw material substrate (5) and the material to be processed (4) in the range of 30 mm to 200 mm enables adjusting a deposition rate of a carbon film formed by the carbon film forming apparatus according to any one of claims 1 to 9 in the range of 1 nm per minute to 700 nm per hour.

**11.** The carbon film forming apparatus according to any of claims 1 to 9, **characterized in that** a carbon film formed by the carbon film forming apparatus according to any one of claims 1 to 9 is adjustable to have a characteristic band having a peak in 800 to 200 cm-1 and a peak intensity ratio of a G band and a D band that is 0.4 or more and 2.0 or less or an intensity area ratio that is 1.5 or more and 3.2 or less in Raman optical spectra using a YAG laser.

**12.** The carbon film forming apparatus according to any one of claims 1 to 9, **characterized in that** installing the substrate (2) for holding the material to be processed (4) as a substrate in the film forming vacuum chamber (10) enables operating the film forming vacuum chamber (10) alone.

**13.** The carbon film forming apparatus according to any one of claims 1 to 9, **characterized in that** the material to be processed (4) that is held on the substrate (2) is any one of polyethylene, polyester, polyethylene terephthalate, polyimide, SiC (silicon carbide), an aluminum alloy, alumina, SUJ2 (a high-carbon chromium bearing steel material), WC (tungsten carbide), an Si wafer, a fiber product, and biodegradable plastic.

**14.** The carbon film forming apparatus according to any one of claims 1 to 9, **characterized in that** a gas that is introduced into the vacuum chamber (11) is any one of nitrogen, argon, krypton, oxygen, and a hydrocarbon-based gas, or a mixed gas of these materials.

**15.** The carbon film forming apparatus according to any one of claims 1 to 9, **characterized in that** the carbon raw material substrate (5) arranged to face the substrate (2) in the film forming vacuum chamber (10) contains carbon as a main material and also contains one or more selected from titanium, silicon, aluminum, zirconium, zinc, and tungsten.

**Patentansprüche**

**1.** Vorrichtung zur Herstellung von Kohlenstofffilmen, umfassend:

eine Abwickel-Vakuumkammer (20) mit einem zu bearbeitenden gerollten Material (4), das darin installiert ist;

eine Filmherstellungs-Vakuumkammer (10), die verwendet wird, um das zu bearbeitende Material (4), das aus der Abwickel-Vakuumkammer (20) abgewickelt wird, zu bearbeiten; und

eine Aufwickel-Vakuumkammer (30), die zum Aufwickeln des zu bearbeitenden Materials (4), das in der Filmherstellungs-Vakuumkammer (10) bearbeitet wird, in eine Rollenform verwendet wird,

wobei die Vorrichtung zur Herstellung von Kohlenstofffilmen **dadurch gekennzeichnet ist, dass** die Filmherstellungs-Vakuumkammer (10) umfasst:

ein Substrat (2), an das durch ein eine Substratspannung anlegendes Mittel (13) in einer Vakuumkammer (11), in der eine Druckherabsetzung auf einen vorbestimmten Grad eines Vakuums möglich ist, eine vorbestimmte Spannung angelegt wird; und

eine Plasmaerzeugungsquelle, die zumindest ein Substrat (5) eines Kohlenstoffrohmaterials aufweist, das so angeordnet ist, dass es dem Substrat (2) zugewandt ist, ein Plasma aus einer Atmosphäre zur Entladungserzeugung, die in die Vakuumkammer (11) eingeführt wird, basierend auf einer elektrischen Leistung einer Einstellung, die von einem Pulsnetzteil (17) an das Substrat (5) eines Kohlenstoffrohmaterials abgegeben wird, auf dem Substrat (5) eines Kohlenstoffrohmaterials bildet und Elektrizität zusammen mit einem Kohlenstoffrohmaterial vom Substrat (5) eines Kohlenstoffrohmaterials in Richtung des zu bearbeitenden Materials (4) entlädt, das auf dem Substrat (2) gehalten wird,

ein Kohlenstofffilm bearbeitet und auf einer Oberfläche des zu bearbeitenden Materials (4) durch ein Sputter-Verfahren gebildet wird,

das Pulsnetzteil (17) und das eine Substratspannung anlegende Mittel (13) durch eine Oszillationsvorrichtung für ein Gate-Signal und einen Mechanismus verbunden sind, der eine Anfangsspannung einstellt,

das Pulsnetzteil (17) eine Einstellungsschaltung aufweist, die eine Pulsbreite in dem Bereich von 1 $\mu$s bis 200 $\mu$s, eine Verzögerungszeitsteuerung von einem Anlegen einer Spannung an das Substrat eines Kohlenstoffrohmaterials als ein Ziel bis zu einem Anlegen einer Substratspannung in dem Bereich von 0 $\mu$s bis 200 $\mu$s, eine Frequenz in dem Bereich von 50 Hz bis 2000 Hz und eine Spannung in dem Bereich von 700 V bis 2000 V steuert, und

das eine Substratspannung anlegende Mittel (13) eine Einstellungsschaltung aufweist, die eine Pulsbreite in dem Bereich von 10 $\mu$s bis 200 $\mu$s, eine Verzögerungszeitsteuerung von einem Anlegen einer Spannung an das Substrat (2) als ein Ziel bis zu einem Anlegen einer Substratspannung in dem Bereich von 0 $\mu$s bis 200 $\mu$s, eine Frequenz in dem Bereich von 50 Hz bis 2000 Hz und eine Spannung in dem Bereich von 0 V bis 500 V steuert.

2. Vorrichtung zur Herstellung von Kohlenstofffilmen nach Anspruch 1, **dadurch gekennzeichnet, dass** eine Stromdichte, die von dem Pulsnetzteil (17) an das Substrat (5) eines Kohlenstoffrohmaterials abgegeben wird, in dem Bereich von 0,1 kA/m$^2$ bis 6 kA/m$^2$ pro Flächeneinheit gesteuert wird.

3. Vorrichtung zur Herstellung von Kohlenstofffilmen nach Anspruch 1, **dadurch gekennzeichnet, dass** ein Steuern der elektrischen Leistung, die von dem Pulsnetzteil (17) an das Substrat (5) eines Kohlenstoffrohmaterials angelegt wird, in dem Bereich von 0,5 kW / m$^2$ bis 3000 kW / m$^2$ pro Flächeneinheit ein Steuern einer Härte und einer Abscheidungsrate in einem gegebenen Gebiet ermöglicht.

4. Vorrichtung zur Herstellung von Kohlenstofffilmen nach Anspruch 1, **dadurch gekennzeichnet, dass** das Substrat (5) eines Kohlenstoffrohmaterials mit einem Meßkopf, der eine Temperatur misst, und einem Mechanismus, der eine Temperatur einstellt, ausgestattet ist und ein Durchführen eines Heizens, bis eine Oberflächentemperatur des Substrats eines Kohlenstoffrohmaterials 1000 °C oder mehr erreicht, und ein Steuern eines Dampfdrucks des vom Substrat (5) eines Kohlenstoffrohmaterials verdampften Rohmaterials, so dass er 0,001 Pa bis 130 Pa erreicht, ein Steuern einer Härte/Abscheidungsrate in einem gegebenen Gebiet ermöglichen.

5. Vorrichtung zur Herstellung von Kohlenstofffilmen nach einem der Ansprüche 1 bis 4, **dadurch gekennzeichnet, dass** ein Einstellen von Werten einer Spannung und eines Stroms, die an das Substrat (5) eines Kohlenstoffrohmaterials angelegt werden, unter Verwendung eines Impedanzanpassungswiderstands ein Steuern der Impedanz in der Vorrichtung bezüglich jeder Schaltung ermöglicht, so dass sie in den Bereich von 20 % bis 70 % fällt.

6. Vorrichtung zur Herstellung von Kohlenstofffilmen nach einem der Ansprüche 1 bis 4, **dadurch gekennzeichnet, dass** erlaubt wird, dass eine von dem eine Substratspannung anlegenden Mittel (13) an das Substrat (2) angelegte Spannung in dem Bereich von 0 bis 500 V festgelegt wird und, wenn die von dem eine Substratspannung anlegenden Mittel (13) angelegte Substratspannung in drei Muster klassifiziert wird, d.h. (1) von einer Zielspannung AN zu einer Zielspannung AUS, (2) von der Zielspannung AUS zu einem Ende einer Filmherstellungszeit und (3) von der Zielspannung AN zum Ende der Filmherstellungszeit während einer gesamten Filmherstellungsperiode, die von dem eine Substratspannung anlegenden Mittel (13) angelegte Substratspannung während des Musters (1) von der Zielspannung AN bis zur Zielspannung AUS angelegt wird.

7. Vorrichtung zur Herstellung von Kohlenstofffilmen nach einem der Ansprüche 1 bis 4, **dadurch gekennzeichnet, dass** erlaubt wird, dass eine von dem eine Substratspannung anlegenden Mittel (13) an das Substrat (2) angelegte Spannung in dem Bereich von 0 bis 500 V festgelegt wird und, wenn die von dem eine Substratspannung anlegenden Mittel (13) angelegte Substratspannung in drei Muster klassifiziert wird, d.h. (1) von einer Zielspannung AN zu einer Zielspannung AUS, (2) von der Zielspannung AUS zu einem Ende einer Filmherstellungszeit und (3) von der Zielspannung AN zum Ende der Filmherstellungszeit während einer gesamten Filmherstellungsperiode, die von dem eine Substratspannung anlegenden Mittel (13) an angelegte Substratspannung während des Musters (2) von der Zielspannung AUS bis zum Ende der Filmherstellung angelegt wird.

8. Vorrichtung zur Herstellung von Kohlenstofffilmen nach einem der Ansprüche 1 bis 4, **dadurch gekennzeichnet, dass** erlaubt wird, dass eine von dem eine Substratspannung anlegenden Mittel (13) an das Substrat (2) angelegte Spannung in dem Bereich von 0 bis 500 V festgelegt wird und, wenn die von dem eine Substratspannung anlegenden Mittel (13) angelegte Substratspannung in drei Muster klassifiziert wird, d.h. (1) von einer Zielspannung AN zu einer Zielspannung AUS, (2) von der Zielspannung AUS zu einem Ende einer Filmherstellungszeit und (3) von der Zielspannung AN zum Ende der Filmherstellungszeit während einer gesamten Filmherstellungsperiode, die von dem eine Substratspannung anlegenden Mittel (13) an angelegte Substratspannung während des Musters (3) von der Zielspannung AN bis zum Ende der Filmherstellung angelegt wird.

9. Vorrichtung zur Herstellung von Kohlenstofffilmen nach einem der Ansprüche 1 bis 7, **dadurch gekennzeichnet, dass** das eine Substratspannung anlegende Mittel (13) ein Pulsnetzteil ist, das eine Pulsspannung an das Substrat (2) abgibt, und die Pulsspannung mit einer Pulsspannung in der elektrischen Leistung einer Einstellung, die von dem Pulsnetzteil (17) der Plasmaerzeugungsquelle an das Substrat (5) eines Kohlenstoffrohmaterials abgegeben wird, synchronisiert oder im Bereich von 1 $\mu$s bis 200 $\mu$s verzögert ist.

10. Vorrichtung zur Herstellung von Kohlenstofffilmen nach einem der Ansprüche 1 bis 9, **dadurch gekennzeichnet, dass** ein Einstellen eines Spalts zwischen dem Substrat (5) eines Kohlenstoffrohmaterials und dem zu bearbeitenden Material (4) in dem Bereich von 30 mm bis 200 mm ein Einstellen einer Abscheidungsrate eines Kohlenstofffilms, der mittels der Vorrichtung zur Herstellung von Kohlenstofffilmen nach einem der Ansprüche 1 bis 9 geschaffen wird, in dem Bereich von 1 nm pro Minute bis 700 nm pro Stunde ermöglicht.

11. Vorrichtung zur Herstellung von Kohlenstofffilmen nach einem der Ansprüche 1 bis 9, **dadurch gekennzeichnet, dass** ein Kohlenstofffilm, der mittels der Vorrichtung zur Herstellung von Kohlenstofffilmen nach einem der Ansprüche 1 bis 9 geschaffen wird, so einstellbar ist, dass er ein charakteristisches Band mit einer Spitze in 800 bis 200 cm-1 und ein Spitzenintensitätsverhältnis eines G-Bandes und eines D-Bandes, das 0,4 oder mehr und 2,0 oder weniger beträgt, oder ein Intensitätsflächenverhältnis, das 1,5 oder mehr und 3,2 oder weniger beträgt, in einem optischen Ramanspektrum unter Verwendung eines YAG-Lasers aufweist.

12. Vorrichtung zur Herstellung von Kohlenstofffilmen nach einem der Ansprüche 1 bis 9, **dadurch gekennzeichnet, dass** ein Installieren des Substarts (2) zum Halten des zu bearbeitenden Materials (4) als ein Substrat in der Filmherstellungs-Vakuumkammer (10) erlaubt, die Filmherstellungs-Vakuumkammer (10) allein zu betreiben.

13. Vorrichtung zur Herstellung von Kohlenstofffilmen nach einem der Ansprüche 1 bis 9, **dadurch gekennzeichnet, dass** das zu bearbeitende Material (4), das auf dem Substrat (2) gehalten wird, eines von Polyethylen, Polyester, Polyethylenterephthalat, Polyimid, SiC (Siliziumcarbid), einer Aluminiumlegierung, Aluminiumoxid, SUJ2 (eines Stahlmaterials mit hohem Kohlenstoff- und Chromgehalt), WC (Wolframcarbid), eines Si-Wafers, eines Faserprodukts und biologisch abbaubaren Kunststoffen ist.

14. Vorrichtung zur Herstellung von Kohlenstofffilmen nach einem der Ansprüche 1 bis 9, **dadurch gekennzeichnet, dass** ein in die Vakuumkammer (11) eingeführtes Gas irgendeines von Stickstoff, Argon, Krypton, Sauerstoff und eines Gases auf Kohlenwasserstoffbasis oder ein gemischtes Gas dieser Materialen ist.

15. Vorrichtung zur Herstellung von Kohlenstofffilmen nach einem der Ansprüche 1 bis 9, **dadurch gekennzeichnet, dass** das Substrat (5) eines Kohlenstoffrohmaterials, das so angeordnet ist, dass es dem Substrat (2) in der Filmherstellungs-Vakuumkammer (10) zugewandt ist, Kohlenstoff als ein Hauptmaterial enthält und auch eines oder mehrere enthält, die aus Titan, Silizium, Aluminium, Zirkonium, Zink und Wolfram ausgewählt werden.

**Revendications**

1.  Dispositif de formation de film de carbone comprenant :

    une chambre à vide de déroulage (20) comprenant un matériau enroulé devant être traité (4) qui est installé dans celle-ci ;
    une chambre à vide de formation de film (10) utilisée pour traiter le matériau devant être traité (4) qui est déroulé à partir de la chambre à vide de déroulage (20) ; et
    une chambre à vide d'enroulage (30) utilisée pour enrouler sous la forme d'un rouleau le matériau devant être traité (4) qui est traité dans la chambre à vide de formation de film (10),
    le dispositif de formation de film de carbone étant **caractérisé en ce que** la chambre à vide de formation de film (10) comprend :

    un substrat (2) auquel une tension prédéterminée est appliquée par des moyens d'application de tension à un substrat (13) dans une chambre à vide (11) dans laquelle une dépressurisation jusqu'à un degré de vide prédéterminé est possible ; et
    une source de génération de plasma qui comporte au moins un substrat de matière première carbonée (5) qui est agencé de manière à faire face au substrat (2), qui forme un plasma à partir d'une atmosphère pour la génération d'une décharge introduite dans la chambre à vide (11) sur la base d'une puissance électrique fournie d'ajustement au substrat de matière première carbonée (5) par une alimentation électrique pulsée (17) sur le substrat de matière première carbonée (5), et qui décharge de l'électricité conjointement avec une matière première carbonée à partir du substrat de matière première carbonée (5) en direction du matériau devant être traité (4) qui est maintenu sur le substrat (2),
    un film de carbone est traité et formé sur une surface du matériau devant être traité (4) par un procédé de pulvérisation cathodique,
    l'alimentation électrique pulsée (17) et le moyen d'application de tension à un substrat (13) sont connectés par un dispositif d'oscillation pour un signal de grille et un mécanisme qui ajuste la tension initiale,
    l'alimentation électrique pulsée (17) comporte un circuit d'ajustement qui commande la largeur d'impulsion dans la plage allant de 1 µs à 200 µs, le temps d'attente entre l'application d'une tension au substrat de matière première carbonée servant de cible à l'application d'une tension au substrat dans la plage allant de 0 µs à 200 µs, la fréquence dans la plage allant de 50 Hz à 2000 Hz, et la tension dans la plage allant de 700 V à 2000 V, et
    le moyen d'application de tension à un substrat (13) comporte un circuit d'ajustement qui commande la largeur d'impulsion dans la plage allant de 10 µs à 200 µs, le temps d'attente entre l'application d'une tension au substrat (2) servant de cible à l'application d'une tension au substrat dans la plage allant de 0 µs à 200 µs, la fréquence dans la plage allant de 50 Hz à 2000 Hz, et la tension dans la plage allant de 0 V à 500 V.

2.  Dispositif de formation de film de carbone selon la revendication 1, **caractérisé en ce que** la densité de courant qui est délivrée en sortie au substrat de matière première carbonée (5) par l'alimentation électrique pulsée (17) est commandée dans la plage allant de 0,1 kA/m$^2$ à 6 kA/m$^2$ par unité de surface.

3.  Dispositif de formation de film de carbone selon la revendication 1, **caractérisé en ce que** la commande de l'énergie électrique appliquée au substrat de matière première carbonée (5) par l'alimentation électrique pulsée (17) dans la plage allant de 0,5 kW/m$^2$ à 3000 kW/m$^2$ par unité de surface permet un contrôle de la dureté et de la vitesse de déposition dans une région donnée.

4.  Dispositif de formation de film de carbone selon la revendication 1, **caractérisé en ce que** le substrat de matière première carbonée (5) est équipé d'un capteur qui mesure la température et d'un mécanisme qui ajuste la température, et la mise en oeuvre d'un chauffage jusqu'à ce que la température de surface du substrat de matière première carbonée atteigne 1000°C ou plus et la commande de la pression de vapeur de la matière première évaporée du substrat de matière première (5) pour qu'elle atteigne 0,001 Pa à 130 Pa permettent un contrôle de la dureté/de la vitesse de déposition dans une région donnée.

5.  Dispositif de formation de film de carbone selon l'une quelconque des revendications 1 à 4, **caractérisé en ce que** l'ajustement des valeurs de tension et de sortie de courant sur le substrat de matière première carbonée (5) utilisant une résistance à adaptation d'impédances permet un contrôle de l'impédance dans le dispositif pour chaque circuit de façon qu'elle soit située dans la plage allant de 20 % à 70 %.

6. Dispositif de formation de film de carbone selon l'une quelconque des revendications 1 à 4, **caractérisé en ce que** la tension appliquée au substrat (2) par le moyen d'application de tension à un substrat (13) est autorisée à être située dans la plage allant de 0 à 500 V et, quand la tension du substrat appliquée par le moyen d'application de tension à un substrat (13) est classée en trois schémas, à savoir (1) d'une tension cible Marche à une tension cible Arrêt, (2) de la tension cible Arrêt à la fin du temps de formation de film, et (3) de la tension de cible Marche à la fin du temps de formation de film durant une période totale de formation de film, la tension du substrat appliquée par le moyen d'application de tension à un substrat (13) est appliquée durant le schéma (1) allant de la tension cible Marche à la tension cible Arrêt.

7. Dispositif de formation de film de carbone selon l'une quelconque des revendications 1 à 4, **caractérisé en ce que** la tension appliquée au substrat (2) par le moyen d'application de tension à un substrat (13) est autorisée à être située dans la plage allant de 0 à 500 V et, quand la tension du substrat appliquée par le moyen d'application de tension à un substrat (13) est classée en trois schémas, à savoir (1) d'une tension cible Marche à une tension cible Arrêt, (2) de la tension cible Arrêt à la fin du temps de formation de film, et (3) de la tension de cible Marche à la fin du temps de formation de film durant une période totale de formation de film, la tension du substrat appliquée par le moyen d'application de tension à un substrat (13) est appliquée durant le schéma (2) allant de la tension cible Arrêt à la fin de la formation de film.

8. Dispositif de formation de film de carbone selon l'une quelconque des revendications 1 à 4, **caractérisé en ce que** la tension appliquée au substrat (2) par le moyen d'application de tension à un substrat (13) est autorisée à être située dans la plage allant de 0 à 500 V et, quand la tension du substrat appliquée par le moyen d'application de tension à un substrat (13) est classée en trois schémas, à savoir (1) d'une tension cible Marche à une tension cible Arrêt, (2) de la tension cible Arrêt à la fin du temps de formation de film, et (3) de la tension de cible Marche à la fin du temps de formation de film durant une période totale de formation de film, la tension du substrat appliquée par le moyen d'application de tension à un substrat (13) est appliquée durant le schéma (3) allant de la tension cible Marche à la fin de la formation de film.

9. Dispositif de formation de film de carbone selon l'une quelconque des revendications 1 à 7, **caractérisé en ce que** le moyen d'application de tension à un substrat (13) est une alimentation électrique pulsée qui délivre en sortie une tension pulsée au substrat (2), et la tension pulsée est synchronisée avec une tension pulsée dans la sortie d'une puissance électrique d'ajustement au substrat de matière première carbonée (5) par l'alimentation électrique pulsée (17) de la source de génération de plasma ou retardée de 1 $\mu$s à 200 $\mu$s.

10. Dispositif de formation de film de carbone selon l'une quelconque des revendications 1 à 9, **caractérisé en ce qu'**un ajustement d'un espace entre le substrat de matière première carbonée (5) et le matériau devant être traité (4) dans la plage allant de 30 mm à 200 mm permet un ajustement de la vitesse de déposition d'un film de carbone formé par le dispositif de formation de film de carbone selon l'une quelconque des revendications 1 à 9 dans la plage allant de 1 nm par minute à 700 nm par heure.

11. Dispositif de formation de film de carbone selon l'une quelconque des revendications 1 à 9, **caractérisé en ce qu'**un film de carbone formé par le dispositif de formation de film de carbone selon l'une quelconque des revendications 1 à 9 est ajustable de manière à présenter une bande caractéristique dotée d'un pic de 800 à 200 cm$^{-1}$ et un rapport des intensités de pics d'une bande G et d'une bande D qui est de 0,4 ou plus et de 2,0 ou moins ou un rapport des surfaces d'intensités qui est de 1,5 ou plus et de 3,2 ou moins dans un spectre optique Raman utilisant un laser YAG.

12. Dispositif de formation de film de carbone selon l'une quelconque des revendications 1 à 9, **caractérisé en ce que** l'installation du substrat (2) pour maintenir le matériau devant être traité (4) sous la forme d'un substrat dans la chambre à vide de formation de film (10) permet un fonctionnement de la chambre à vide de formation de film (10) seule.

13. Dispositif de formation de film de carbone selon l'une quelconque des revendications 1 à 9, **caractérisé en ce que** le matériau devant être traité (4) qui est maintenu sur le substrat (2) est l'un quelconque parmi le polyéthylène, le polyester, le poly(téréphtalate d'éthylène), le polyimide, le SiC (carbure de silicium), un alliage d'aluminium, l'alumine, le SUJ2 (un matériau en acier à forte teneur en carbone contenant du chrome), le WC (carbure de tungstène), une galette de Si, un produit fibreux, et une matière plastique biodégradable.

**14.** Dispositif de formation de film de carbone selon l'une quelconque des revendications 1 à 9, **caractérisé en ce qu'**un gaz qui est introduit dans la chambre à vide (11) est l'un quelconque parmi l'azote, l'argon, le krypton, l'oxygène, et un gaz hydrocarboné, ou un mélange gazeux de ces matériaux.

**15.** Dispositif de formation de film de carbone selon l'une quelconque des revendications 1 à 9, **caractérisé en ce que** le substrat de matière carbonée (5) agencé de manière à faire face au substrat (2) dans la chambre à vide de formation de film (10) contient du carbone en tant que matériau principal et contient aussi un ou plusieurs choisi parmi le titane, le silicium, l'aluminium, le zirconium, le zinc et le tungstène.

F i g . 1

EXHAUST

Fig. 2

17

$E_0$　$C_0$

SWITCHING CIRCUIT

IMPEDANCE MATCHING MECHANISM

TO CARBON RAW MATERIAL SUBSTRATE 5

19

15

13

TO SUBSTRATE

SWITCHING CIRCUIT

16

18

SETTING OF REPETITION FREQUENCY

SETTING OF PULSE WIDTH

Fig. 3

2　　2

4

20　　21

5　　5　　10　　5　5　　5　　10

6　　6

30

TAKE-UP VACUUM CHAMBER

31

F i g . 4

F i g . 5

F i g . 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5643343 A
- JP 2003147508 A
- JP 2008297171 A
- JP 2007070667 A
- JP 2010174310 A